# EUROPÄISCHE PATENTANMELDUNG

(11) **EP 4 604 178 A1**
(43) Veröffentlichungstag der Anmeldung: **20.08.2025**
(21) Anmeldenummer: 24158165.1
(22) Anmeldetag: 16.02.2024
(51) Int. Cl.: H01L 23/427, H05K 1/02, H05K 7/20

(54) **LEISTUNGSHALBLEITERANORDNUNG MIT EINEM SCHALTUNGSTRÄGER, EINER WÄRMESENKE UND EINER ELEKTRONISCHEN SCHALTUNG SOWIE VERFAHREN ZU DEREN HERSTELLUNG**

(71) Anmelder: Siemens Aktiengesellschaft, 80333 München (DE)
(72) Erfinder: Bigl, Thomas, 91074 Herzogenaurach (DE); Hensler, Alexander, 91466 Gerhardshofen (DE); Schwarz, Florian, 90766 Fürth (DE); Stegmeier, Stefan, 81825 München (DE)
(74) Vertreter: Siemens Patent Attorneys

(57) **Zusammenfassung**

Die Erfindung betrifft eine Leistungshalbleiteranordnung (2) aufweisend einen Schaltungsträger (4), eine Wärmesenke (6) und zumindest eine elektronische Schaltung (8), welche zumindest ein Leistungshalbleiterelement (14) und zumindest einen Zwischenkreiskondensator (16) aufweist. Um das Schaltverhalten einer Leistungshalbleiteranordnung (2) zu verbessern und dabei eine ausreichende Kühlung zu gewährleisten, wird vorgeschlagen, dass die elektronische Schaltung (8) in einem ersten Bereich (22) mit dem Schaltungsträger (4) verbunden ist, wobei die Wärmesenke (6) in einem zweiten Bereich (24), welcher vom ersten Bereich (22) horizontal beabstandet ist, mit dem Schaltungsträger (4) verbunden ist, wobei der Schaltungsträger (4) eine Wärmeleitung (26) mit einer Kanalstruktur (28), in welcher ein Wärmetransportfluid (30) angeordnet ist, aufweist, wobei im ersten Bereich (22) zumindest ein erster Kanal (32) der Kanalstruktur (28) und im zweiten Bereich (24) zumindest ein zweiter Kanal (34) der Kanalstruktur (28) angeordnet sind, wobei der zumindest eine erste Kanal (32) in fluidtechnischer Verbindung mit dem zumindest einen zweiten Kanal (34) steht, sodass die elektronische Schaltung (8) über die Wärmeleitung (26) thermisch leitend mit der Wärmesenke (6) verbunden ist.

## Beschreibung

Die Erfindung betrifft eine Leistungshalbleiteranordnung aufweisend einen Schaltungsträger, eine Wärmesenke und zumindest eine elektronische Schaltung, welche zumindest ein Leistungshalbleiterelement und zumindest einen Zwischenkreiskondensator aufweist.

Ferner betrifft die Erfindung einen Stromrichter mit mindestens einer derartigen Leistungshalbleiteranordnung.

Darüber hinaus betrifft die Erfindung ein Verfahren zur Herstellung einer Leistungshalbleiteranordnung aufweisend einen Schaltungsträger, eine Wärmesenke und zumindest eine elektronische Schaltung, welche zumindest ein Leistungshalbleiterelement und zumindest einen Zwischenkreiskondensator aufweist.

Eine derartige Leistungshalbleiteranordnung kommt beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Üblicherweise sind derartige Leistungshalbleiteranordnungen als Leistungsmodule ausgeführt. Die in der Leistungshalbleiteranordnung zum Einsatz kommenden Leistungshalbleiterelement sind unter anderem Transistoren, Triacs, Thyristoren oder Dioden. Derartige Transistoren können unter anderem als Insulated-Gate-Bipolar-Transistoren (IGBTs) oder als Wide-Bandgap-Transistoren ausgeführt. Die Wide-Bandgap-Transistoren können beispielsweise in Siliziumcarbid- oder Galliumnitrid-Technologie realisiert sein und ermöglichen unter anderem höhere Schaltfrequenzen.

Die Offenlegungsschrift EP 3 958 306 A1 beschreibt ein Leistungsmodul mit mindestens zwei auf einem Substrat kontaktierten Leistungshalbleiteranordnungen, welche in einem Gehäuse angeordnet sind.

Eine planare Aufbau- und Verbindungstechnik von elektronischen Schaltungen führt nicht nur zu geringeren parasitären Induktivitäten der Leistungshalbleiter, was höhere Schaltfrequenzen ermöglicht, sondern auch zu erhöhten Leistungsdichten.

Die Offenlegungsschrift WO 2020/249479 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet.

Die Offenlegungsschrift EP 4 300 574 A1 beschreibt ein bestückbares Leistungsmodul umfassend ein Leistungssubstrat mit einer Metallisierung, zumindest ein schaltbarer Die mit Leistungsanschlüssen, einen Interposer und zumindest ein erstes und ein zweites Kontaktelement, wobei die Kontaktelemente jeweils eine elektrische Kontaktierung einer der Leistungsanschlüsse des Dies am Interposer bereitstellen.

Um eine ausreichende Kühlung einer elektronischen Schaltung in einer Leistungshalbleiteranordnung zu gewährleisten, wird eine Wärmesenke möglichst nahe der Leistungshalbleiteranordnung positioniert. Um eine effektive Entwärmung zu erreichen, kann eine Wärmeleitung zum Einsatz kommen. In einer derartigen Wärmeleitung, auch Wärmerohr genannt, ist üblicherweise ein Wärmetransportfluid für eine Zwei-Phasen-Kühlung angeordnet. Die Wärmeleitung kann unter anderem als Heatpipe, pulsierende Heatpipe oder Thermosiphon ausgeführt sein.

Die Offenlegungsschrift WO 2022/214231 A1 beschreibt eine Halbleitermodulanordnung aufweisend einen Kühlkörper und zumindest ein Halbleitermodul, welches auf dem Kühlkörper kontaktiert ist. Um, im Vergleich zum Stand der Technik, eine effektivere Entwärmung und eine kostengünstigere Herstellung zu ermöglichen, wird vorgeschlagen, dass der Kühlkörper einen Kühlkörpergrundkörper und einen Kühlkörperaufsatz umfasst, wobei der Kühlkörperaufsatz auf einer ersten Oberfläche eine Kanalstruktur aufweist, in welcher ein Wärmetransportfluid angeordnet ist, wobei der Kühlkörpergrundkörper eine Kühlkörpergrundkörperoberfläche aufweist, wobei die Kanalstruktur durch eine stoffschlüssige Verbindung mit der Kühlkörpergrundkörperoberfläche des Kühlkörpergrundkörpers hermetisch verschlossen ist, sodass sowohl der Kühlkörperaufsatz als auch der Kühlkörpergrundkörper in unmittelbarem Kontakt mit dem Wärmetransportfluid stehen, wobei durch die hermetisch verschlossene Kanalstruktur und das Wärmetransportfluid eine pulsierende Heatpipe ausgebildet ist, welche mit dem Halbleitermodul in einer thermisch leitfähigen Verbindung steht.

Die Offenlegungsschrift WO 2021/099019 A1 beschreibt Elektronikmodul. Das Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Üblicherweise werden Zwischenkreiskondensatoren, welche üblicherweise als Elektrolytkondensatoren ausgeführt sind, aus Platzgründen weiter beabstandet zur Leistungshalbleiteranordnung angeordnet, was eine optimale niederinduktive elektrische Anbindung der Zwischenkreiskondensatoren an die Leistungshalbleiteranordnung erschwert. Insbesondere entsteht durch den Abstand zwischen Leistungshalbleiteranordnung und Zwischenkreiskondensatoren eine hohe Kommutierungsinduktivität, welche sich nachteilig auf das Schaltverhalten der Leistungshalbleiteranordnung auswirkt.

Vor diesem Hintergrund ist es eine Aufgabe der vorliegenden Erfindung, das Schaltverhalten einer Leistungshalbleiteranordnung zu verbessern und dabei eine ausreichende Kühlung zu gewährleisten.

Diese Aufgabe wird erfindungsgemäß gelöst durch eine Leistungshalbleiteranordnung aufweisend einen Schaltungsträger, eine Wärmesenke und zumindest eine elektronische Schaltung, welche zumindest ein Leistungshalbleiterelement und zumindest einen Zwischenkreiskondensator aufweist, wobei die elektronische Schaltung mit einem ersten Bereich des Schaltungsträgers verbunden ist, wobei die Wärmesenke mit einem zweiten Bereich des Schaltungsträgers, welcher vom ersten Bereich horizontal beabstandet angeordnet ist, verbunden ist, wobei der Schaltungsträger eine Wärmeleitung mit einer Kanalstruktur, in welcher ein Wärmetransportfluid angeordnet ist, aufweist, wobei im ersten Bereich des Schaltungsträgers zumindest ein erster Kanal der Kanalstruktur und im zweiten Bereich des Schaltungsträgers zumindest ein zweiter Kanal der Kanalstruktur angeordnet sind, wobei der zumindest eine erste Kanal in fluidtechnischer Verbindung mit dem zumindest einen zweiten Kanal steht, sodass die elektronische Schaltung über die Wärmeleitung thermisch leitend mit der Wärmesenke verbunden ist.

Ferner wird die Aufgabe erfindungsgemäß gelöst durch einen Stromrichter mit mindestens einer derartigen Leistungshalbleiteranordnung.

Darüber hinaus wird die Aufgabe erfindungsgemäß gelöst durch ein Verfahren zur Herstellung einer Leistungshalbleiteranordnung aufweisend einen Schaltungsträger, eine Wärmesenke und zumindest eine elektronische Schaltung, welche zumindest ein Leistungshalbleiterelement und zumindest einen Zwischenkreiskondensator aufweist, wobei die elektronische Schaltung in einem ersten Bereich mit dem Schaltungsträger verbunden wird, wobei die Wärmesenke in einem zweiten Bereich, welcher vom ersten Bereich horizontal beabstandet ist, mit dem Schaltungsträger verbunden wird, wobei der Schaltungsträger eine Wärmeleitung mit einer Kanalstruktur, in welcher ein Wärmetransportfluid angeordnet wird, aufweist, wobei im ersten Bereich zumindest ein erster Kanal der Kanalstruktur und im zweiten Bereich zumindest ein zweiter Kanal der Kanalstruktur angeordnet werden, wobei der zumindest eine erste Kanal fluidtechnisch mit dem zumindest einen zweiten Kanal verbunden wird, sodass die elektronische Schaltung über die Wärmeleitung thermisch leitend mit der Wärmesenke verbunden wird.

Die in Bezug auf die Leistungshalbleiteranordnung nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, das Schaltverhalten einer Leistungshalbleiteranordnung zu verbessern, indem die Kommutierungsinduktivität einer elektronischen Schaltung der Leistungshalbleiteranordnung verringert wird. Die elektronische Schaltung weist zumindest ein Leistungshalbleiterelement und zumindest einen Zwischenkreiskondensator auf, welche auf einem Schaltungsträger verbunden sind. Der Schaltungsträger kann unter anderem ein Substrat aufweisen, welches zumindest eine, insbesondere beidseitig metallisierte dielektrische Materiallage umfasst. Der Schaltungsträger kann mehrere miteinander verbundene Substrate aufweisen. Beispielsweise können das zumindest eine Leistungshalbleiterelement und der zumindest eine Zwischenkreiskondensator stoffschlüssig, insbesondere durch Löten und/oder Sintern, mit einer strukturierten Metallisierung des Substrats verbunden sein. Das zumindest eine Leistungshalbleiterelement kann unter anderem einen IGBT und/oder einen Wide-Bandgap-Transistor umfassen. Eine Mehrzahl an Leistungshalbleiterelementen, welche insbesondere Transistoren und Dioden umfassen können, kann zu einem elektronischen Schaltkreis, beispielsweise zu einer Halbbrücke, verschaltet sein. Während eines Betriebes der Leistungshalbleiteranordnung wird eine in der elektronischen Schaltung entstehende Verlustwärme über eine Wärmesenke, welche beispielsweise einen metallischen Kühlkörper umfasst, abgeführt.

Zur Verringerung der Kommutierungsinduktivität wird die elektronische Schaltung mit dem zumindest einen Leistungshalbleiterelement und dem zumindest einen Zwischenkreiskondensator in einem ersten Bereich mit dem Schaltungsträger verbunden, sodass ein möglichst geringer Abstand zwischen dem zumindest einen Leistungshalbleiterelement und dem zumindest einen Zwischenkreiskondensator erreicht wird. Auf diese Weise wird eine optimale niederinduktive elektrische Anbindung der Zwischenkreiskondensatoren an die Leistungshalbleiteranordnung erreicht. Da der zumindest eine Zwischenkreiskondensator, welcher z.B. als Elektrolytkondensator ausgeführt ist, einen vergleichsweise großen Bauraum beansprucht, wird die Wärmesenke in einem zweiten Bereich, welcher vom ersten Bereich horizontal, das heißt in Richtung einer Oberfläche des Schaltungsträgers, beabstandet ist, mit dem Schaltungsträger verbunden. Insbesondere kann durch eine derartige Anordnung ein Abstand zwischen dem zumindest einen Leistungshalbleiterelement und dem zumindest einen Zwischenkreiskondensator deutlich geringer sein als ein Abstand der Wärmesenke zum zumindest einen Leistungshalbleiterelement bzw. zum zumindest einen Zwischenkreiskondensator.

Um dennoch eine ausreichende Kühlung zu gewährleisten, weist der Schaltungsträger eine Wärmeleitung auf, über welche die elektronische Schaltung thermisch leitend mit der Wärmesenke verbunden ist. Die Wärmeleitung, auch Wärmerohr genannt, weist eine Kanalstruktur auf, in welcher ein Wärmetransportfluid angeordnet ist. Insbesondere ist das in der Kanalstruktur angeordnete Wärmetransportfluid aufgrund seiner Wärmeleitfähigkeit und seines Siedepunkts für eine Zwei-Phasen-Kühlung der elektronischen Schaltung konfiguriert. Die Wärmeleitung kann unter anderem als Heatpipe, pulsierende Heatpipe oder Thermosiphon ausgeführt sein. Im ersten Bereich ist zumindest ein erster Kanal der Kanalstruktur und im zweiten Bereich zumindest ein zweiter Kanal der Kanalstruktur angeordnet, wobei der zumindest eine erste Kanal in fluidtechnischer Verbindung mit dem zumindest einen zweiten Kanal steht. Durch eine derartige Anordnung mit verringerter Kommutierungsinduktivität wird das Schaltverhalten der elektronischen Schaltung verbessert, wobei die Wärmeleitung eine Entwärmung gewährleistet.

Eine weitere Ausführungsform sieht vor, dass der Schaltungsträger eine Leiterplatte mit einer ersten Oberfläche und einer auf einer der ersten Oberfläche gegenüberliegenden Seite angeordneten zweiten Oberfläche aufweist, wobei die Wärmeleitung flächig mit einer Oberfläche der Leiterplatte verbunden ist. Beispielsweise ist die Kanalstruktur im Grundkörper der Wärmeleitung eingebracht und wird durch die, insbesondere im Wesentlichen ebene, erste Oberfläche der Leiterplatte fluiddicht verschlossen. Alternativ kann die Kanalstruktur, insbesondere vollständig, im Grundkörper verlaufend angeordnet sein, wobei der Grundkörper vollflächig mit der ersten Oberfläche der Leiterplatte, beispielsweise durch Adhäsion, verbunden ist. Durch eine derartige Anordnung wird eine zuverlässige und effiziente Entwärmung gewährleistet.

Eine weitere Ausführungsform sieht vor, dass die Wärmeleitung zwischen der Leiterplatte und dem zumindest einen Zwischenkreiskondensator angeordnet ist, wobei der zumindest eine Zwischenkreiskondensator, insbesondere in Durchstecktechnik realisierte, Anschlüsse aufweist, welche durch die Wärmeleitung verlaufend angeordnet und, insbesondere stoffschlüssig, mit der Leiterplatte verbunden sind. Eine derartige stoffschlüssige Verbindung des Zwischenkreiskondensators mit der Leiterplatte kann unter anderem durch Löten hergestellt werden. Durch die Anordnung der Wärmeleitung zwischen der Leiterplatte und dem zumindest einen Zwischenkreiskondensator wird eine im zumindest einen Zwischenkreiskondensator entstehende Abwärme effizient über die Wärmeleitung abgeführt, während eine zuverlässige Verbindung mit der Leiterplatte gewährleistet ist.

Eine weitere Ausführungsform sieht vor, dass die Anschlüsse zumindest eines Zwischenkreiskondensator in unmittelbarem Kontakt mit dem Wärmetransportfluid der Wärmeleitung stehen. Dadurch wird der Temperaturwiderstand verringert und die Wärmeabfuhr vom zumindest einen Zwischenkreiskondensator zur Wärmesenke verbessert.

Eine weitere Ausführungsform sieht vor, dass die Wärmesenke und der zumindest eine Zwischenkreiskondensator auf derselben Oberfläche des Schaltungsträgers angeordnet sind. Sowohl die Wärmesenke als auch der zumindest eine Zwischenkreiskondensator beanspruchen, insbesondere im Vergleich zu den weiteren Komponenten auf dem Schaltungsträger und insbesondere in vertikaler Richtung, einen großen Bauraum. Eine derartige Anordnung derselben Oberfläche des Schaltungsträgers ermöglicht eine flexible und kompakte Positionierung der weiteren Komponenten, was zusätzlich parasitäre Induktivitäten verringert.

Eine weitere Ausführungsform sieht vor, dass die Wärmesenke in unmittelbarem Kontakt mit dem Wärmetransportfluid der Wärmeleitung steht. Dadurch wird der Temperaturwiederstand verringert und die Wärmeabfuhr zur Wärmesenke verbessert.

Eine weitere Ausführungsform sieht vor, dass der zumindest eine zweite Kanal der Kanalstruktur im zweiten Bereich zumindest teilweise durch die Wärmesenke verlaufend angeordnet ist. Insbesondere ist die Wärmesenke als metallischer Kühlkörper ausgeführt, in welchen der zumindest eine zweite Kanal zumindest teilweise eingebracht wird. Das Einbringen kann unter anderem mittels eines spanenden Verfahrens, z.B. Fräsen, erfolgen. Durch einen zumindest teilweise durch die, insbesondere metallische, Wärmesenke verlaufenden Kanal wird eine verbesserte Wärmeabfuhr erreicht.

Eine weitere Ausführungsform sieht vor, dass die Wärmesenke aus einem ersten metallischen Werkstoff hergestellt ist und zumindest in Angrenzung an den zweiten Kanal der Kanalstruktur einen zweiten metallischen Werkstoff umfasst, welcher eine höhere thermische Leitfähigkeit als der erste metallische Werkstoff aufweist. Beispielsweise ist die als Kühlkörper ausgeführte Wärmesenke aus einer Aluminiumlegierung hergestellt, wobei die Beschichtung aus Kupfer oder einer Kupferlegierung hergestellt ist. Durch die höhere Leitfähigkeit des Kupfers wird die Wärmeabfuhr verbessert.

Eine weitere Ausführungsform sieht vor, dass die Wärmeleitung zumindest im ersten Bereich einen Grundkörper aufweist, wobei der Grundkörper zumindest teilweise aus einem dielektrischen Werkstoff hergestellt ist. Der dielektrische bzw. elektrisch nicht-leitfähige Werkstoff kann unter anderem ein Polymer oder einen keramischen Werkstoff enthalten. Ein keramischer Werkstoff ermöglicht eine elektrisch isolierende Ausführung des Grundkörpers mit guten thermischen Eigenschaften. Insbesondere bei Verwendung vertikaler Leistungshalbleiterelemente, wie beispielsweise IGBTs, ist ein zumindest teilweise aus einem dielektrischen Werkstoff hergestellter Grundkörper, welcher eine elektrisch isolierende und thermisch leitfähige Verbindung zur Wärmesenke herstellt, vorteilhaft.

Eine weitere Ausführungsform sieht vor, dass der Schaltungsträger einen in einer Kavität angeordneten Metallkern aufweist, wobei zumindest ein Leistungshalbleiterelement stoffschlüssig mit dem Metallkern verbunden ist. Ein derartiger Metallkern kann unter anderem aus Kupfer oder einer Kupferlegierung hergestellt sein. Insbesondere füllt der Metallkern die Kavität vollständig aus und schließt im Wesentlichen planbündig mit der Oberfläche des Schaltungsträgers ab. Ein derartiger Metallkern ist eine zwischen dem zumindest einen Leistungshalbleiterelement und der Wärmeleitung angeordnete Wärmekapazität, welche bei einem Kaltstart der Leistungshalbleiteranordnung eine Anlaufzeit einer pulsierenden Heatpipe hilft zu überbrücken. Eine derartige Kavität kann teilweise oder vollständig durch den Schaltungsträger verlaufen. Eine vollständig durch den Schaltungsträger verlaufende Kavität, welche aus Ausnehmung genannt werden kann, kann mit einem Metallkern, der beispielsweise als Metall-Insert, insbesondere als "Kupfer-Coin", verfüllt werden. Eine teilweise durch den Schaltungsträger verlaufende Kavität kann unter anderem durch eingebettete Dickkupferstrukturen gefüllt werden. Ferner sorgt der Metallkern für eine Wärmespreizung.

Eine weitere Ausführungsform sieht vor, dass der Metallkern in unmittelbarem Kontakt mit dem Wärmetransportfluid der Wärmeleitung steht. Insbesondere steht der Metallkern auf einer dem Leistungshalbleiterelement abgewandten Seite in unmittelbarem Kontakt mit dem Wärmetransportfluid, wodurch eine verbesserte Wärmeabfuhr erreicht wird.

Eine weitere Ausführungsform sieht vor, dass zumindest ein Leistungshalbleiterelement als vertikales Leistungshalbleiterelement ausgeführt und mittels planarer Aufbau- und Verbindungstechnik stoffschlüssig mit dem Schaltungsträger verbunden ist. Ein vertikales Leistungshalbleiterelement weist einen ersten und einen zweiten Lastanschluss auf, wobei das Leistungshalbleiterelement ausgelegt ist, einen Laststrom entlang einer vertikalen Richtung zwischen dem ersten und dem zweiten Lastanschluss zu leiten. Ein vertikales Leistungshalbleiterelement kann unter anderem ein IGBT oder ein vertikaler SiC-MOS-FET sein. Planare Aufbau- und Verbindungstechnik zeichnet sich durch den Wegfall von für konventionelle Aufbau- und Verbindungstechnik erforderliche Spezialtechnologien, wie beispielsweise Drahtbonden, aus. Die Lastanschlüsse des vertikales Leistungshalbleiterelements werden beidseitig mit planaren Verbindungsmitteln, z.B. mit einem Substrat, insbesondere einem Printed Circuit Board (PCB) und/oder einem DCB (Direct Copper Bonded) Substrat, kontaktiert. Durch die Verwendung planarer Aufbau- und Verbindungstechnik wird eine verbesserte Zuverlässigkeit und eine Verlängerung der Lebensdauer erreicht.

Eine weitere Ausführungsform sieht vor, dass zumindest ein Leistungshalbleiterelement auf einer Oberfläche zwischen mindestens zwei Zwischenkreiskondensatoren angeordnet ist. Ist das zumindest eine Leistungshalbleiterelement auf einer Oberfläche horizontal zwischen den mindestens zwei Zwischenkreiskondensatoren angeordnet, werden kürzere Zuleitungen und somit eine geringere Kommutierungsinduktivität erreicht.

Im Folgenden wird die Erfindung anhand der in den Figuren dargestellten Ausführungsbeispiele näher beschrieben und erläutert.

Es zeigen:
- FIG 1: eine schematische Schnittdarstellung einer ersten Ausführungsform einer Leistungshalbleiteranordnung,
- FIG 2: eine schematische Schnittdarstellung einer zweiten Ausführungsform einer Leistungshalbleiteranordnung,
- FIG 3: eine schematische Schnittdarstellung einer dritten Ausführungsform einer Leistungshalbleiteranordnung,
- FIG 4: eine vergrößerte schematische Schnittdarstellung einer vierten Ausführungsform einer Leistungshalbleiteranordnung,
- FIG 5: eine vergrößerte schematische Schnittdarstellung einer fünften Ausführungsform einer Leistungshalbleiteranordnung,
- FIG 6: eine schematische Schnittdarstellung einer sechsten Ausführungsform einer Leistungshalbleiteranordnung,
- FIG 7: eine schematische Darstellung eines Ausschnitts einer Wärmeleitung,
- FIG 8: eine schematische Darstellung eines Spritzgussverfahrens zur Herstellung eines Grundkörperteils,
- FIG 9: eine vergrößerte schematische Schnittdarstellung einer sechsten Ausführungsform einer Leistungshalbleiteranordnung,
- FIG 10: eine vergrößerte schematische Schnittdarstellung einer siebten Ausführungsform einer Leistungshalbleiteranordnung,
- FIG 11: schematische Schnittdarstellung einer achten Ausführungsform der Leistungshalbleiteranordnung in einer Draufsicht,
- FIG 12: eine vergrößerte schematische Schnittdarstellung einer neunten Ausführungsform einer Leistungshalbleiteranordnung,
- FIG 13: eine schematische Schnittdarstellung einer neunten Ausführungsform einer Leistungshalbleiteranordnung,
- FIG 14: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

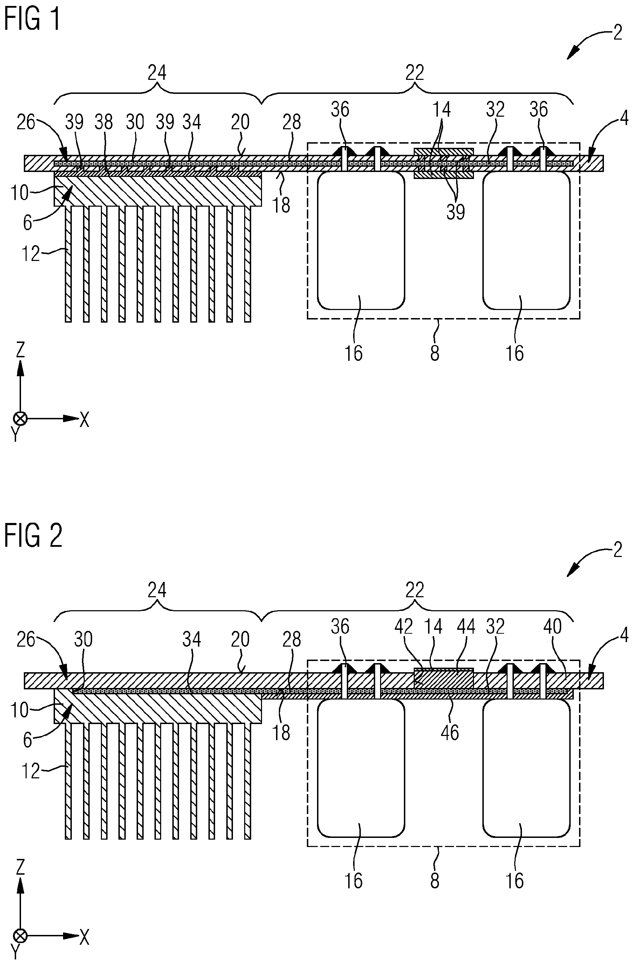

FIG 1 zeigt eine schematische Schnittdarstellung einer ersten Ausführungsform einer Leistungshalbleiteranordnung 2, welche einen Schaltungsträger 4, eine Wärmesenke 6 und eine elektronische Schaltung 8 aufweist. Die Wärmesenke 6 ist beispielhaft als metallischer Kühlkörper ausgeführt, welcher eine Kühlkörpergrundplatte 10 und Kühlrippen 12 aufweist. Der metallische Kühlkörper ist aus einem ersten metallischen Werkstoff hergestellt, der unter anderem Aluminium oder eine Aluminiumlegierung enthalten kann. Beispielsweise wird der Kühlkörper aus einer Aluminiumlegierung mittels Strangpressen hergestellt. Die elektronische Schaltung 8 umfasst Leistungshalbleiterelemente 14, welche beispielsweise einen IGBT und/oder einen Wide-Bandgap-Transistor aufweisen können, sowie Zwischenkreiskondensatoren 16. Der Schaltungsträger 4 weist eine im Wesentlichen ebene erste Oberfläche 18 und eine auf einer der ersten Oberfläche 18 gegenüberliegenden Seite angeordnete im Wesentlichen ebene zweite Oberfläche 20 auf. Durch die im Wesentlichen ebene zweite Oberfläche 20 wird eine horizontale xy-Ebene definiert.

Die Leistungshalbleiterelemente 14 und Zwischenkreiskondensatoren 16 der elektronischen Schaltung 8 sind in einem ersten Bereich 22, insbesondere stoffschlüssig, mit dem Schaltungsträger 4 verbunden, wobei die Leistungshalbleiterelemente 14 beidseitig mit dem Schaltungsträger 4 verbunden sind. Die Leistungshalbleiterelemente 14 sind horizontal zwischen den Zwischenkreiskondensatoren 16 angeordnet, was zu kürzeren Zuleitungen und somit zu einer geringeren Kommutierungsinduktivität führt. Die Wärmesenke 6 ist in einem zweiten Bereich 24 mit dem Schaltungsträger 4 verbunden, wobei der zweite Bereich 24 vom ersten Bereich 22 horizontal beabstandet angeordnet ist. Die Wärmesenke 6 und die Zwischenkreiskondensatoren 16 sind auf der ersten Oberfläche 18 des Schaltungsträgers 4 angeordnet.

Der Schaltungsträger 4 weist eine Wärmeleitung 26 mit einer Kanalstruktur 28, in welcher ein Wärmetransportfluid 30 angeordnet ist, auf, wobei das Wärmetransportfluid 30 für eine Zwei-Phasen-Kühlung konfiguriert ist. Die Wärmeleitung 26 kann unter anderem als Heatpipe, pulsierende Heatpipe oder Thermosiphon ausgeführt sein. Im ersten Bereich 22 des Schaltungsträgers 4 ist zumindest ein erster Kanal 32 der Kanalstruktur 28 und im zweiten Bereich 24 des Schaltungsträgers 4 ist zumindest ein zweiter Kanal 34 der Kanalstruktur 28 angeordnet. Der zumindest eine erste Kanal 32 steht in fluidtechnischer Verbindung mit dem zumindest einen zweiten Kanal 34, wobei die Kanäle 32, 34 die Kanalstruktur 28 der Wärmeleitung 26 ausbilden. Beispielsweise weist der Schaltungsträger 4 eine Mehrzahl von Lagen auf, welche jeweils einen dielektrischen und/oder einen metallischen Werkstoff enthalten, wobei die Kanalstruktur 28 der Wärmeleitung 26 in zumindest eine Lage des Schaltungsträgers 4 integriert ist. Ferner wird die Kanalstruktur 28 vertikal bzw. in z-Richtung beidseitig durch benachbarte Lagen fluiddicht verschlossen. Beispielsweise ist eine mäanderförmige Kanalstruktur 28 in zumindest eine Lage des lagenförmig aufgebauten Schaltungsträgers 4 eingebracht. Als Wärmetransportfluid 30 kann ein elektrisch leitfähiges oder elektrisch nicht-leitfähiges Fluid zum Einsatz kommen. Unter anderem kommen Wasser-Glykol-Gemische, dielektrische Flüssigkeiten und/oder Öle infrage.

Die Zwischenkreiskondensatoren 16 sind beispielhaft als Aluminium-Elektrolytkondensatoren in Durchstecktechnik ausgeführt und weisen Anschlüsse 36 auf, welche durch die Wärmeleitung 26 und den Schaltungsträger 4 verlaufend angeordnet sind. Beispielhaft sind die Anschlüsse 36 der Zwischenkreiskondensatoren 16 stoffschlüssig, insbesondere durch Löten, auf der zweiten Oberfläche 20 verbunden. Der erste Kanal 32 ist um die Anschlüsse 36 der Zwischenkreiskondensatoren 16 herum verlaufend angeordnet. Der Kühlkörper ist, beispielsweise stoffschlüssig, mit einer auf der ersten Oberfläche 18 des Schaltungsträgers 4 angeordneten Metallisierung 38 verbunden, wobei die Metallisierung 38 über metallische Durchkontaktierungen 39, insbesondere "thermal vias", thermisch mit der Wärmeleitung 26 verbunden ist. Die Leistungshalbleiterelemente 14 sind ebenfalls über metallische Durchkontaktierungen 39 mit der Wärmeleitung 26 verbunden. Somit sind die horizontal von der Wärmesenke 6 beabstandeten Leistungshalbleiterelemente 14 und Zwischenkreiskondensatoren 16 der elektronischen Schaltung 8 über die Wärmeleitung 26 thermisch leitend mit der Wärmesenke 6 verbunden.

FIG 2 zeigt eine schematische Schnittdarstellung einer zweiten Ausführungsform einer Leistungshalbleiteranordnung 2. Der Schaltungsträger 4 weist eine Leiterplatte 40 mit einer ersten Oberfläche 18 und einer zweiten Oberfläche 20 auf, wobei die Leiterplatte 40 beispielhaft als Printed Circuit Board (PCB) ausgeführt ist und eine Mehrzahl an Lagen aufweisen kann. Die Leiterplatte 40 weist ferner eine Kavität 42 auf, in welcher ein Metallkern 44, welcher insbesondere aus Kupfer oder einer Kupferlegierung hergestellt ist, angeordnet ist. Die Kavität 42 ist vollständig durch die Leiterplatte 40 verlaufend angeordnet und kann für diesen Fall auch als Ausnehmung in der Leiterplatte 40 bezeichnet werden. Der Metallkern 44, welcher die Ausnehmung vollständig ausfüllt, ist als Metall-Insert, insbesondere als "Kupfer-Coin", ausgeführt. Derartige Leiterplatten 40 mit zumindest einem in einer Ausnehmung angeordneten "Kupfer-Coin" wird aucb "Copper Coin PCB" genannt. Insbesondere schließt der Metallkern 44 die Kavität 42 im Wesentlichen planbündig mit der zweiten Oberfläche 20 ab. Zumindest ein Leistungshalbleiterelement 14 ist stoffschlüssig mit dem Metallkern 44 verbunden. Auf einer dem zumindest einen Leistungshalbleiterelement 14 abgewandten Seite steht der Metallkern 44 in unmittelbarem Kontakt mit dem Wärmetransportfluid 30 der Wärmeleitung 26.

Die Wärmeleitung 26 weist einen zumindest teilweise aus einem dielektrischen Werkstoff hergestellten Grundkörper 46 auf, welcher flächig mit der ersten Oberfläche 18 der Leiterplatte 40 verbunden ist. Beispielsweise ist die Kanalstruktur 28 im ersten Bereich 22 im Grundkörper 46 der Wärmeleitung 26 eingebracht und wird durch die im Wesentlichen ebene erste Oberfläche 18 der Leiterplatte 40 fluiddicht verschlossen. Alternativ kann die Kanalstruktur 28 im ersten Bereich 22 im Grundkörper 46 verlaufend angeordnet sein, wobei der Grundkörper 46 vollflächig mit der ersten Oberfläche 18 der Leiterplatte 40, insbesondere adhäsiv, verbunden ist. Der erste Kanal 32 der Kanalstruktur 28 verläuft parallel zur ersten Oberfläche 18 durch den Grundkörper 46, wobei insbesondere eine mäanderförmige Kanalstruktur ausgebildet wird, um eine möglichst gute Wärmespreizung zu gewährleisten. Im ersten Bereich 22 ist die Wärmeleitung 26 somit vertikal zwischen der Leiterplatte 40 und den Zwischenkreiskondensatoren 16 angeordnet.

Darüber hinaus ist die Wärmeleitung 26 im Bereich des zweiten Kanals 34 der Kanalstruktur 28 durch die Kühlkörpergrundplatte 10 des Kühlkörpers verlaufend angeordnet, wobei der zweite Kanal 34, insbesondere zumindest teilweise mäanderförmig, parallel zur ersten Oberfläche 18 durch die die Kühlkörpergrundplatte 10 verläuft. Beispielsweise ist der zweite Kanal 34 der Kanalstruktur 28 auf einer der den Kühlrippen 12 abgewandten Seite in die Kühlkörpergrundplatte 10 des Kühlkörpers, insbesondere mittels eines spanenden Verfahrens, eingebracht und ist durch Verbindung des Grundkörpers 46 mit der im Wesentlichen ebenen ersten Oberfläche 18 der Leiterplatte 40 fluiddicht verschlossen. Die Kühlkörpergrundplatte 10 ist mit dem Grundkörper 46, beispielsweise mittels Adhäsion, stoffschlüssig verbunden, sodass der erste Kanal 32 in fluidtechnischer Verbindung mit dem zweiten Kanal 34 steht und die Wärmeleitung 26 fluiddicht gekapselt ist. Die weitere Ausgestaltung der Leistungshalbleiteranordnung 2 in FIG 2 entspricht der in FIG 1.

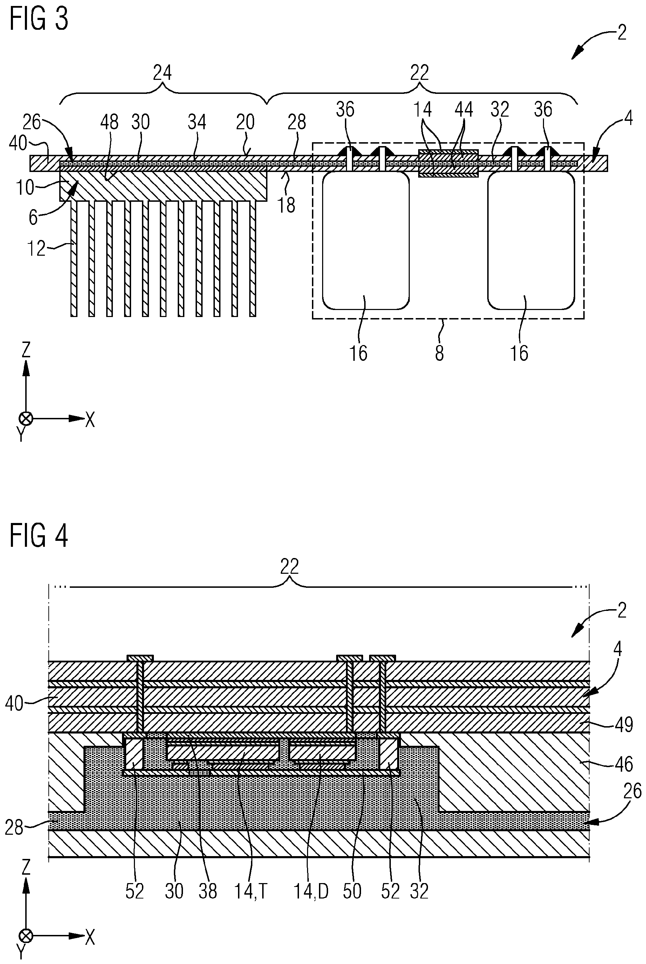

FIG 3 zeigt eine schematische Schnittdarstellung einer dritten Ausführungsform einer Leistungshalbleiteranordnung 2. Der Schaltungsträger 4 weist eine Leiterplatte 40 mit einer ersten Oberfläche 18 und einer zweiten Oberfläche 20 auf, wobei die Leiterplatte 40 eine Mehrzahl von Lagen aufweist, welche jeweils einen dielektrischen und/oder einen metallischen Werkstoff enthalten. Der erste Kanal 32 der Kanalstruktur 28 der Wärmeleitung 26 ist im ersten Bereich 22 in einer Lage der Leiterplatte 40 angeordnet, wobei der erste Kanal 32 der Kanalstruktur 28 vertikal bzw. in z-Richtung beidseitig durch benachbarte Lagen fluiddicht verschlossen ist.

Der zweite Kanal 34 der Kanalstruktur 28 im zweiten Bereich 24 ist durch die Kühlkörpergrundplatte 10 des Kühlkörpers verlaufend angeordnet, wobei die Kühlkörpergrundplatte 10 in Angrenzung an den zweiten Kanal 32 eine Beschichtung 48 aus einem zweiten metallischen Werkstoff aufweist, wobei der zweite metallische Werkstoff eine höhere thermische Leitfähigkeit als der erste metallische Werkstoff aufweist. Beispielsweise weist der aus einer Aluminiumlegierung hergestellte Kühlkörper eine Beschichtung aus Kupfer oder einer Kupferlegierung auf. Die Beschichtung 48 der Kühlkörpergrundplatte 10 steht somit in unmittelbarem Kontakt mit dem Wärmetransportfluid 30 der Wärmeleitung 26 und verschließt den zweiten Kanal 34 im zweiten Bereich 24 fluiddicht. Die weitere Ausgestaltung der Leistungshalbleiteranordnung 2 in FIG 3 entspricht der in FIG 2.

FIG 4 zeigt eine vergrößerte schematische Schnittdarstellung einer vierten Ausführungsform einer Leistungshalbleiteranordnung 2, wobei der Grundkörper 46 der Wärmeleitung 26 aus einem dielektrischen bzw. elektrisch nicht-leitfähigen Werkstoffhergestellt ist. Der dielektrische Werkstoff des Grundkörpers kann unter anderem ein Polymer oder einen keramischen Werkstoff enthalten. Ein keramischer Werkstoff ermöglicht eine elektrisch isolierende Ausführung des Grundkörpers 46 mit guten thermischen Eigenschaften. Das Wärmetransportfluid 30 ist ein elektrisch nicht-leitfähiges Fluid. Beispielsweise kommt Perfluor-N-alkyl-morpholin aufgrund seiner hohen Wärmeleitfähigkeit, seines Siedepunkts und seiner dielektrischen Eigenschaften gut als elektrisch nicht-leitfähiges Wärmetransportfluid 30 für die Wärmeleitung 26 infrage.

Der Schaltungsträger 4 umfasst eine mehrlagige Leiterplatte 40. Ferner sind vertikale Leistungshalbleiterelemente 14 mittels planarer Aufbau- und Verbindungstechnik stoffschlüssig mit dem Schaltungsträger 4 verbunden. Durch den Wegfall von für konventionelle Aufbau- und Verbindungstechnik erforderlichen Spezialtechnologien, wie beispielsweise Drahtbonden, wird eine verbesserte Zuverlässigkeit der Leistungshalbleiteranordnung 2 und eine Verlängerung der Lebensdauer erreicht. Beispielhaft sind ein Transistor T und eine antiparallel zum Transistor T geschaltete Diode D stoffschlüssig mit einer strukturierten Metallisierung 38 einer Außenlage 49 der Leiterplatte 40 verbunden. Auf einer der Leiterplatte 40 abgewandten Seite sind die vertikalen Leistungshalbleiterelemente 14 stoffschlüssig mit einem Metallrahmen 50, welcher beispielsweise Kupfer enthält, verbunden. Die stoffschlüssigen Verbindungen werden beispielsweise durch Löten oder Sintern hergestellt. Über Verbindungselemente 52 werden die von der Leiterplatte 40 abgewandten Anschlüsse der vertikalen Leistungshalbleiterelemente 14 mit der Metallisierung 38 der Außenlage 49 der Leiterplatte 40 verbunden. Die Leistungshalbleiterelemente 14 stehen unmittelbar im Kontakt mit dem elektrisch nicht-leitfähigen Fluid. Die weitere Ausgestaltung der Leistungshalbleiteranordnung 2 in FIG 3 entspricht der in FIG 2.

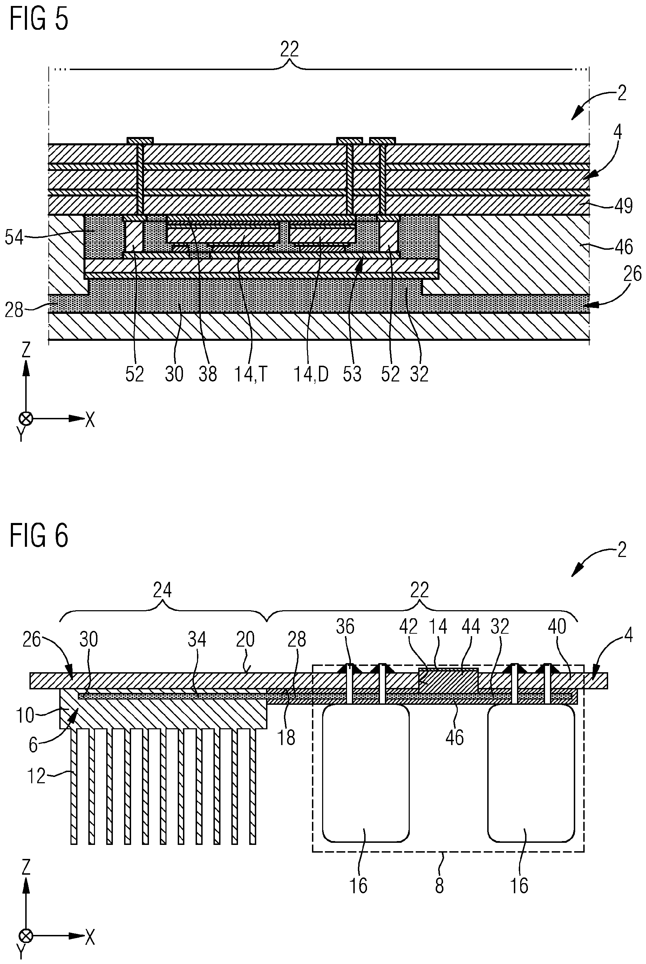

FIG 5 zeigt eine vergrößerte schematische Schnittdarstellung einer fünften Ausführungsform einer Leistungshalbleiteranordnung 2, wobei der Grundkörper 46 der Wärmeleitung 26 aus einem metallischen und somit elektrisch leitfähigen Werkstoffhergestellt ist. Auf einer der Leiterplatte 40 abgewandten Seite sind die vertikalen Leistungshalbleiterelemente 14 stoffschlüssig mit einem Substrat 53, insbesondere einem DCB (Direct Copper Bonded) Substrat, verbunden. Die Leistungshalbleiterelemente 14 und die Verbindungselemente 52 sind in ein Vergussmaterial 54 eingebettet, das beispielsweise mit Hilfe eines Underfillers gefertigt ist.

FIG 6 zeigt eine schematische Schnittdarstellung einer sechsten Ausführungsform einer Leistungshalbleiteranordnung 2. Im ersten Bereich 22 weist die Wärmeleitung 26 einen Grundkörper 46 auf, der, wie in FIG 4 gezeigt, aus einem dielektrischen bzw. elektrisch nicht-leitfähigen Werkstoffhergestellt hergestellt ist und den ersten Kanal 32 auch vertikal bzw. in z-Richtung fluiddicht verschließt. Der zweite Kanal 34 verläuft vollständig und parallel zur ersten Oberfläche 18 durch die Kühlkörpergrundplatte 10 des Kühlkörpers. Der zweite Kanal 34 der Kanalstruktur 28, welcher beispielsweise mäanderförmig durch die Kühlkörpergrundplatte 10 verläuft, wird beispielsweise mittels eines spanenden Verfahrens, eingebracht und anschließend mit einem im Deckel, insbesondere Deckblech, stoffschlüssig verbunden. Beispielsweise wird ein Deckblech zur Ausbildung des zweiten Kanals 34 der Kanalstruktur aufgeschweißt. Durch stoffschlüssiges Verbinden des Grundkörpers 46 mit der Kühlkörpergrundplatte 10, beispielsweise mittels Adhäsion, steht der erste Kanal 32 in fluidtechnischer Verbindung mit dem zweiten Kanal 34 und die Wärmeleitung 26 ist fluiddicht gekapselt. Die weitere Ausgestaltung der Leistungshalbleiteranordnung 2 in FIG 6 entspricht der in FIG 2.

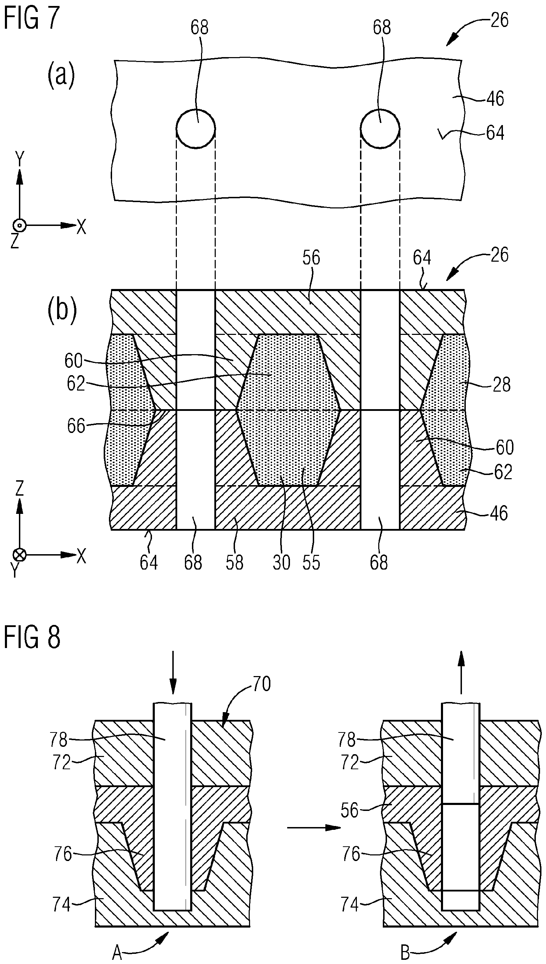

FIG 7 zeigt eine schematische Darstellung eines Ausschnitts einer Wärmeleitung 26, welche in einer Draufsicht (a) und in einer Schnittdarstellung (b) gezeigt ist. Der Grundkörper 46 der Wärmeleitung 26 ist aus einem dielektrischen Werkstoff hergestellt und umfasst einen Hohlraum 55 zur Ausbildung der Kanalstruktur 28, in welcher das Wärmetransportfluid 30 angeordnet ist. Alternativ kann der Grundkörper 46 der Wärmeleitung 26 aus einem metallischen Werkstoff hergestellt sein, der beispielsweise Aluminium und/oder Kupfer enthalten kann. Der Grundkörper 46 ist zweiteilig aus einem ersten Grundkörperteil 56 und einem zweiten Grundkörperteil 58 aufgebaut, welche jeweils Wandungen 60 und zwischen den Wandungen 60 angeordnete Vertiefungen 62 aufweisen. Auf einer den Vertiefungen 62 gegenüberliegenden Seite ist jeweils eine ebene Oberfläche 64 angeordnet. Die Grundkörperteile 56, 58 sind über die jeweiligen korrespondierenden Wandungen 60 miteinander verbunden, wobei zwischen dem ersten Grundkörperteil 56 und dem zweiten Grundkörperteil 58 eine Fügezone 66 ausgebildet ist, welche sich aus einem fluiddichten Fügen, z.B. Verkleben oder Verschweißen, der beiden Hälften ergeben. Durch Kombinieren von korrespondierenden Vertiefungen 62 wird die Kanalstruktur 28 erzeugt. Darüber hinaus weist die Wärmeleitung 26 durchgängige zylindrische Ausnehmungen 68 zur Aufnahme von Anschlüssen 36 der Zwischenkreiskondensatoren 16 auf. Optional kann die Oberfläche eines aus einem elektrisch leitfähigen Material hergestellter Grundkörpers 46 zumindest teilweise mit einem, insbesondere thermisch leitfähigen, Dielektrikum versehen sein.

FIG 8 zeigt eine schematische Darstellung eines Spritzgussverfahrens zur Herstellung eines Grundkörperteils 56. Das Werkzeug 70 für das Spritzgussverfahren weist ein Werkzeugoberteil 72 und ein Werkzeugunterteil 74 auf, zwischen welchen ein Gussraum 76 zur Ausbildung des Grundkörperteils 56 angeordnet ist. Vor dem eigentlichen Spritzgießen A werden, insbesondere zylinderförmige, Platzhalter 78 in den Gussraum 76 eingefügt. Das Spritzgießen kann unter anderem mit einem dielektrischen Werkstoff, insbesondere einem Polymer, erfolgen. Alternativ kann das Spritzgießen mit einem metallischen Werkstoff erfolgen. Nach dem Verfestigen, insbesondere Auskühlen des Grundkörperteils 56 erfolgt ein Entfernen B der Platzhalter 78 aus dem Gussraum 76 zum Erhalt von durchgängigen Ausnehmungen 68 im Grundkörperteil 56. Das Grundkörperteil 56 kann alternativ z.B. additiv mittels eines 3D-Druck-Verfahrens hergestellt werden. Die weitere Ausgestaltung des Grundkörperteils 56 in FIG 8 entspricht der in FIG 7.

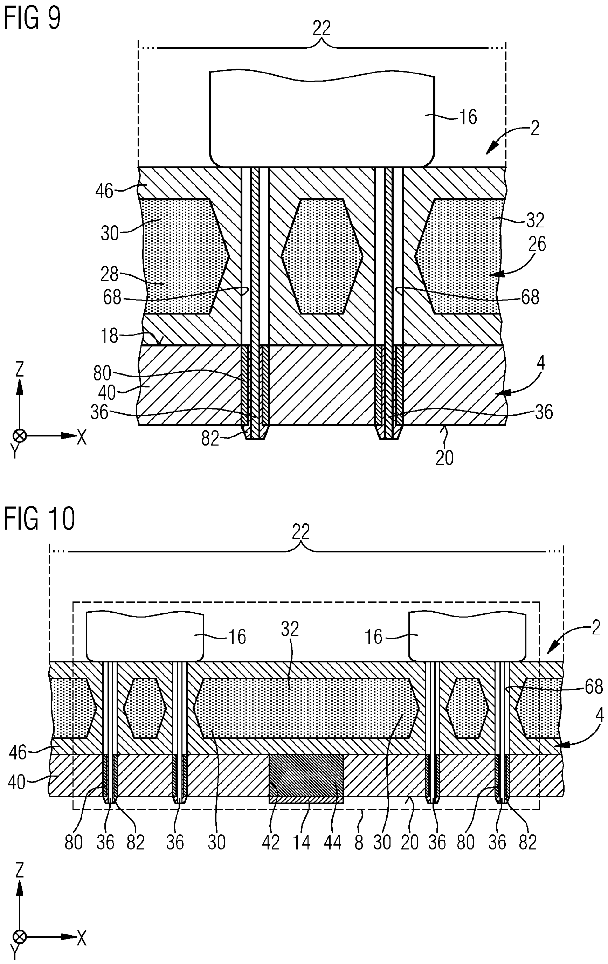

FIG 9 zeigt eine vergrößerte schematische Schnittdarstellung einer sechsten Ausführungsform einer Leistungshalbleiteranordnung 2, welche eine aus einem dielektrischen Werkstoff hergestellte Wärmeleitung 26 aufweist. Der Grundkörper der Wärmeleitung 26 ist flächig mit der ersten Oberfläche 18 der Leiterplatte 40 verbunden, wobei die Wärmeleitung 26 zwischen der Leiterplatte 40 und einem Zwischenkreiskondensator 16, welcher in Durchstecktechnik implementiert ist, angeordnet ist. Der Zwischenkreiskondensator 16 weist Anschlüsse 36 auf, welche durch die Ausnehmungen 68 der Wärmeleitung 26 verlaufend angeordnet und stoffschlüssig mit der Leiterplatte 40 verbunden sind. Beispielhaft sind die Anschlüsse 36 über metallische Durchkontaktierungen 80 geführt und über eine Lötverbindung 82 stoffschlüssig verbunden. Die weitere Ausgestaltung der Leistungshalbleiteranordnung 2 in FIG 9 entspricht der in FIG 6.

FIG 10 zeigt eine vergrößerte schematische Schnittdarstellung einer siebten Ausführungsform einer Leistungshalbleiteranordnung 2, wobei zumindest ein Leistungshalbleiterelement 14 stoffschlüssig mit einem Metallkern 44 verbunden ist. Der Metallkern 44 steht in unmittelbarem Kontakt mit dem Grundkörper 46 der Wärmeleitung 26. Die Leistungshalbleiterelemente 14 und Zwischenkreiskondensatoren 16 sind vertikal auf gegenüberliegenden Seiten des Schaltungsträgers 4 angeordnet. Ferner sind die Leistungshalbleiterelemente 14 horizontal zwischen den Zwischenkreiskondensatoren 16 angeordnet, was zu kürzeren Zuleitungen und somit zu einer geringeren Kommutierungsinduktivität führt. Die weitere Ausgestaltung der Leistungshalbleiteranordnung 2 in FIG 10 entspricht der in FIG 9.

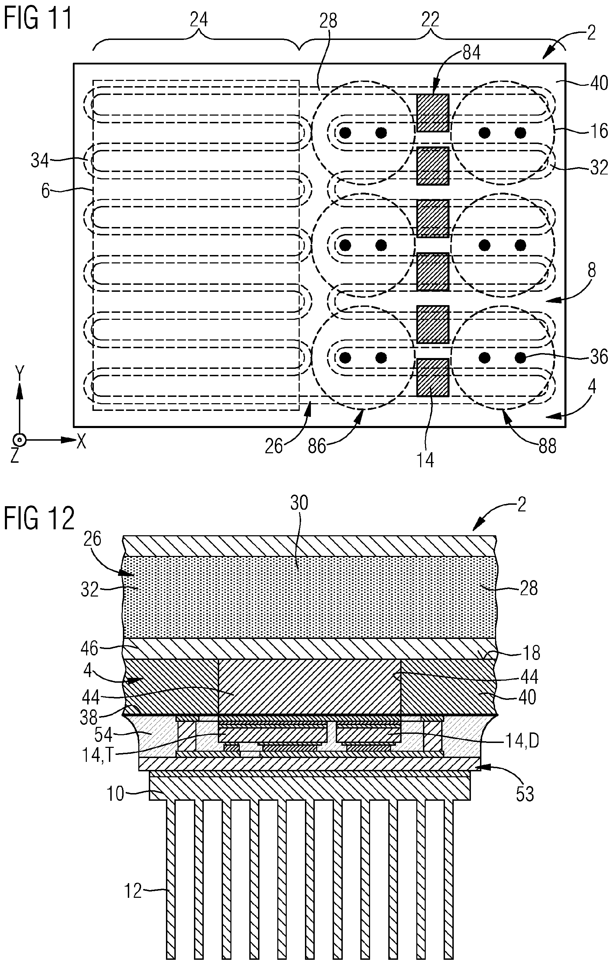

FIG 11 zeigt eine schematische Schnittdarstellung einer achten Ausführungsform der Leistungshalbleiteranordnung 2 in einer Draufsicht. Die elektronische Schaltung 8, welche Leistungshalbleiterelemente 14 und Zwischenkreiskondensatoren 16 umfasst, ist in einem ersten Bereich 22 mit dem Schaltungsträger 4 verbunden, während die Wärmesenke 6 in einem zweiten Bereich 24 mit dem Schaltungsträger 4, wobei der erste Bereich 22 horizontal, beispielhaft parallel zur x-Achse, vom zweiten Bereich 24 beabstandet angeordnet ist. Die Leistungshalbleiterelemente 14 und Zwischenkreiskondensatoren 16 sind in parallel zur y-Achse verlaufenden Reihen 84, 86, 88 angeordnet, wobei die Leistungshalbleiter-Reihe 88 zwischen einer ersten Kondensator-Reihe 84 und einer zweiten Kondensator-Reihe 86 angeordnet ist.

Die Kanalstruktur 28 der Wärmeleitung 26, welche als, insbesondere pulsierende, Heatpipe ausgeführt ist, umfasst einen im ersten Bereich 22, beispielhaft mäanderförmig, verlaufenden ersten Kanal 32 und einen im zweiten Bereich 24, beispielhaft mäanderförmig, verlaufenden zweiten Kanal 34, wobei der erste Kanal 32 in fluidtechnischer Verbindung mit dem zweiten Kanal 34 steht. Die Mäanderstruktur der Kanäle 32, 34 verläuft beispielhaft senkrecht zu den Reihen 84, 86, 88 der Leistungshalbleiterelemente 14 und Zwischenkreiskondensatoren 16. Die beispielhaft jeweils zwei Anschlüsse 36 der Zwischenkreiskondensatoren 16, sind beispielhaft parallel zur Mäanderstruktur des ersten Kanals 32 angeordnet und sind in der Mäanderstruktur des ersten Kanals 32 ausgespart. Die weitere Ausgestaltung der Leistungshalbleiteranordnung 2 in FIG 11 entspricht der in FIG 10.

FIG 12 zeigt eine vergrößerte schematische Schnittdarstellung einer neunten Ausführungsform einer Leistungshalbleiteranordnung 2, wobei, wie in FIG 6 gezeigt, die vertikalen Leistungshalbleiterelemente 14 mittels planarer Aufbau- und Verbindungstechnik stoffschlüssig mit dem Schaltungsträger 4 verbunden sind. Auf einer der Leiterplatte 40 abgewandten Seite sind die vertikalen Leistungshalbleiterelemente 14 stoffschlüssig mit einem DCB Substrat, verbunden. Auf dem Substrat ist auf einer den vertikalen Leistungshalbleiterelementen 14 abgewandten Seite ein zusätzlicher Kühlkörper 90, welcher beispielhaft aus einem metallischen Werkstoff, insbesondere einer Aluminiumlegierung, hergestellt ist und welcher eine Kühlkörpergrundplatte 10 und Kühlrippen 12 aufweist. Die weitere Ausgestaltung der Leistungshalbleiteranordnung 2 in FIG 12 entspricht der in FIG 11.

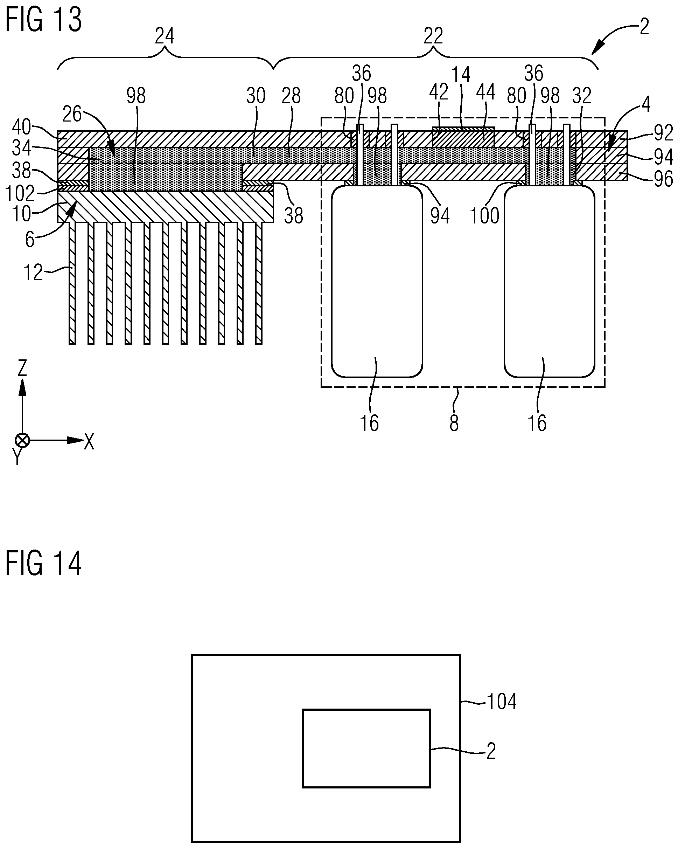

FIG 13 zeigt eine schematische Schnittdarstellung einer neunten Ausführungsform einer Leistungshalbleiteranordnung 2. Die Leiterplatte 40 weist mehrere Lagen 92, 94, 96 auf, welche eine Oberlage 92, beispielhaft eine Mittellage 94 und eine Unterlage 96 umfassen. Die Kanalstruktur 28 der Wärmeleitung 26 ist in die Mittellage 94 der Leiterplatte 40 integriert, die Anschlüsse 36 der Zwischenkreiskondensatoren 16 und die Kühlkörpergrundplatte 10 stehen über Aussparungen 98 in der Unterlage 96 in unmittelbarem Kontakt mit dem Wärmetransportfluid 30. Spalte im Bereich der Aussparungen 98 im ersten Bereich 22 zwischen den Zwischenkreiskondensatoren 16 und der Leiterplatte 40 sind über ein adhäsives, insbesondere dielektrisches, Dichtmaterial 100 fluiddicht verschlossen. Die Kühlkörpergrundplatte 10 verschließt die Aussparung 98 im zweiten Bereich 24 über eine stoffschlüssige Verbindung 102, insbesondere eine Klebeverbindung oder eine Lötverbindung, mit der Metallisierung 38 der Unterlage 96. Somit stehen die Anschlüsse 36 der Zwischenkreiskondensatoren 16 über das Wärmetransportfluid 30 in fluidtechnischer Verbindung mit der Wärmesenke 6. Die weitere Ausgestaltung der Leistungshalbleiteranordnung 2 in FIG 13 entspricht der in FIG 6.

FIG 14 zeigt eine schematische Darstellung eines Stromrichters 104, welcher beispielhaft eine Leistungshalbleiteranordnung 2 umfasst.

Zusammenfassend betrifft die Erfindung eine Leistungshalbleiteranordnung 2 aufweisend einen Schaltungsträger 4, eine Wärmesenke 6 und zumindest eine elektronische Schaltung 8, welche zumindest ein Leistungshalbleiterelement 14 und zumindest einen Zwischenkreiskondensator 16 aufweist. Um das Schaltverhalten einer Leistungshalbleiteranordnung 2 zu verbessern und dabei eine ausreichende Kühlung zu gewährleisten, wird vorgeschlagen, dass die elektronische Schaltung 8 in einem ersten Bereich 22 mit dem Schaltungsträger 4 verbunden ist, wobei die Wärmesenke 6 in einem zweiten Bereich 24, welcher vom ersten Bereich 22 horizontal beabstandet ist, mit dem Schaltungsträger 4 verbunden ist, wobei der Schaltungsträger 4 eine Wärmeleitung 26 mit einer Kanalstruktur 28, in welcher ein Wärmetransportfluid 30 angeordnet ist, aufweist, wobei im ersten Bereich 22 zumindest ein erster Kanal 32 der Kanalstruktur 28 und im zweiten Bereich 24 zumindest ein zweiter Kanal 34 der Kanalstruktur 28 angeordnet sind, wobei der zumindest eine erste Kanal 32 in fluidtechnischer Verbindung mit dem zumindest einen zweiten Kanal 34 steht, sodass die elektronische Schaltung 8 über die Wärmeleitung 26 thermisch leitend mit der Wärmesenke 6 verbunden ist.

## Patentansprüche

1. Leistungshalbleiteranordnung (2) aufweisend einen Schaltungsträger (4), eine Wärmesenke (6) und zumindest eine elektronische Schaltung (8), welche zumindest ein Leistungshalbleiterelement (14) und zumindest einen Zwischenkreiskondensator (16) aufweist,
wobei die elektronische Schaltung (8) in einem ersten Bereich (22) mit dem Schaltungsträger (4) verbunden ist,
wobei die Wärmesenke (6) in einem zweiten Bereich (24), welcher vom ersten Bereich (22) horizontal beabstandet ist, mit dem Schaltungsträger (4) verbunden ist,
wobei der Schaltungsträger (4) eine Wärmeleitung (26) mit einer Kanalstruktur (28), in welcher ein Wärmetransportfluid (30) angeordnet ist, aufweist,
wobei im ersten Bereich (22) zumindest ein erster Kanal (32) der Kanalstruktur (28) und im zweiten Bereich (24) zumindest ein zweiter Kanal (34) der Kanalstruktur (28) angeordnet sind,
wobei der zumindest eine erste Kanal (32) in fluidtechnischer Verbindung mit dem zumindest einen zweiten Kanal (34) steht,
sodass die elektronische Schaltung (8) über die Wärmeleitung (26) thermisch leitend mit der Wärmesenke (6) verbunden ist.

2. Leistungshalbleiteranordnung (2) nach Anspruch 1,
wobei der Schaltungsträger (4) eine Leiterplatte (40) mit einer ersten Oberfläche (18) und einer auf einer der ersten Oberfläche (18) gegenüberliegenden Seite angeordneten zweiten Oberfläche (20) aufweist,
wobei die Wärmeleitung (26) flächig mit einer Oberfläche (18, 20) der Leiterplatte (40) verbunden ist.

3. Leistungshalbleiteranordnung (2) nach Anspruch 2,
wobei die Wärmeleitung (26) zwischen der Leiterplatte (40) und dem zumindest einen Zwischenkreiskondensator (16) angeordnet ist,
wobei der zumindest eine Zwischenkreiskondensator (16), insbesondere in Durchstecktechnik realisierte, Anschlüsse (36) aufweist, welche durch die Wärmeleitung (26) verlaufend angeordnet und, insbesondere stoffschlüssig, mit der Leiterplatte (40) verbunden sind.

4. Leistungshalbleiteranordnung (2) nach Anspruch 3,
wobei die Anschlüsse (36) zumindest eines Zwischenkreiskondensator (16) in unmittelbarem Kontakt mit dem Wärmetransportfluid (30) der Wärmeleitung (26) stehen.

5. Leistungshalbleiteranordnung (2) nach einem der Ansprüche 2 bis 4,
wobei die Wärmesenke (6) und der zumindest eine Zwischenkreiskondensator (16) auf derselben Oberfläche (18, 20) des Schaltungsträgers (4) angeordnet sind.

6. Leistungshalbleiteranordnung (2) nach einem der vorherigen Ansprüche,
wobei die Wärmesenke (6) in unmittelbarem Kontakt mit dem Wärmetransportfluid (30) der Wärmeleitung (26) steht.

7. Leistungshalbleiteranordnung (2) nach einem der vorherigen Ansprüche,
wobei der zumindest eine zweite Kanal (34) der Kanalstruktur (28) im zweiten Bereich (24) zumindest teilweise durch die Wärmesenke (6) verlaufend angeordnet ist.

8. Leistungshalbleiteranordnung (2) nach Anspruch 7,
wobei die Wärmesenke (6) aus einem ersten metallischen Werkstoff hergestellt ist und zumindest in Angrenzung an den zweiten Kanal (34) der Kanalstruktur (28) einen zweiten metallischen Werkstoff umfasst, welcher eine höhere thermische Leitfähigkeit als der erste metallische Werkstoff aufweist.

9. Leistungshalbleiteranordnung (2) nach einem der vorherigen Ansprüche,
wobei die Wärmeleitung (26) zumindest im ersten Bereich (22) einen Grundkörper (46) aufweist,
wobei der Grundkörper (46) zumindest teilweise aus einem dielektrischen Werkstoff hergestellt ist.

10. Leistungshalbleiteranordnung (2) nach einem der vorherigen Ansprüche,
wobei der Schaltungsträger (4) einen in einer Kavität (42) angeordneten Metallkern (44) aufweist,
wobei zumindest ein Leistungshalbleiterelement (14) stoffschlüssig mit dem Metallkern (44) verbunden ist.

11. Leistungshalbleiteranordnung (2) nach Anspruch 10,
wobei der Metallkern (44) in unmittelbarem Kontakt mit dem Wärmetransportfluid (30) der Wärmeleitung (26) steht.

12. Leistungshalbleiteranordnung (2) nach einem der vorherigen Ansprüche,
wobei zumindest ein Leistungshalbleiterelement (2) als vertikales Leistungshalbleiterelement (2) ausgeführt und
mittels planarer Aufbau- und Verbindungstechnik stoffschlüssig mit dem Schaltungsträger (4) verbunden ist.

13. Leistungshalbleiteranordnung (2) nach einem der vorherigen Ansprüche,
wobei zumindest ein Leistungshalbleiterelement (14) auf einer Oberfläche zwischen mindestens zwei Zwischenkreiskondensatoren (16) angeordnet ist

14. Stromrichter (104) mit mindestens einer Leistungshalbleiteranordnung (2) nach einem der vorherigen Ansprüche.

15. Verfahren zur Herstellung einer Leistungshalbleiteranordnung (2) aufweisend einen Schaltungsträger (4), eine Wärmesenke (6) und zumindest eine elektronische Schaltung (8), welche zumindest ein Leistungshalbleiterelement (14) und zumindest einen Zwischenkreiskondensator (16) aufweist,
wobei die elektronische Schaltung (8) in einem ersten Bereich (22) mit dem Schaltungsträger (4) verbunden wird,
wobei die Wärmesenke (6) in einem zweiten Bereich (24), welcher vom ersten Bereich (22) horizontal beabstandet ist, mit dem Schaltungsträger (4) verbunden wird, wobei der Schaltungsträger (4) eine Wärmeleitung (26) mit einer Kanalstruktur (28), in welcher ein Wärmetransportfluid (30) angeordnet wird, aufweist,
wobei im ersten Bereich (22) zumindest ein erster Kanal (32) der Kanalstruktur (28) und im zweiten Bereich (24) zumindest ein zweiter Kanal (34) der Kanalstruktur (28) angeordnet werden,
wobei der zumindest eine erste Kanal (32) fluidtechnisch mit dem zumindest einen zweiten Kanal (34) verbunden wird,
sodass die elektronische Schaltung (8) über die Wärmeleitung (26) thermisch leitend mit der Wärmesenke (6) verbunden wird.

16. Verfahren nach Anspruch 15,
wobei ein Grundkörper (46) der Wärmeleitung (26) aus einem dielektrischen Werkstoff mittels eines Spritzgussverfahrens hergestellt wird,
wobei das Spritzgussverfahren folgende Schritte umfasst:
- Spritzgießen (A) eines ersten Grundkörperteils (56) und eines zweiten Grundkörperteils (58), welche jeweils Vertiefungen (62) aufweisen,
- Fügen der Grundkörperteile (56, 58), wobei durch Kombinieren der Vertiefungen (62) die Kanalstruktur (28) erzeugt wird.

17. Verfahren nach Anspruch 16,
wobei vor dem Spritzgießen, insbesondere zylinderförmige, Platzhalter (78) in den Gussraum (76) eingefügt werden,
wobei nach dem Verfestigen des dielektrischen Werkstoffs ein Entfernen (B) der Platzhalter (78) aus dem Gussraum (76) zum Erhalt von Ausnehmungen (68) im Grundkörperteil (56, 58) erfolgt.
